Europäisches Patentamt

European Patent Office

Office européen des brevets

(19)

(11) Publication number: **0 057 972**

**B1**

(12) **EUROPEAN PATENT SPECIFICATION**

(45) Date of publication of patent specification: **08.10.86**

(21) Application number: **82300076.5**

(22) Date of filing: **07.01.82**

(51) Int. Cl.⁴: **G 07 D 7/00, H 03 K 17/95**

(54) A device for detecting a metal strip embedded in paper.

•㉚ Priority: **12.01.81 JP 2043/81**
**02.04.81 JP 48400/81**
**29.06.81 JP 99620/81**

(43) Date of publication of application:
**18.08.82 Bulletin 82/33**

(45) Publication of the grant of the patent:
**08.10.86 Bulletin 86/41**

(84) Designated Contracting States:
**AT CH DE FR GB IT LI NL SE**

(56) References cited:
**EP-A-0 023 965**
**FR-A-2 455 773**
**GB-A- 595 764**
**GB-A-2 017 996**
**US-A-4 108 296**

The file contains technical information
submitted after the application was filed and
not included in this specification

(73) Proprietor: **Kabushiki Kaisha Toshiba**
**72, Horikawa-cho Saiwai-ku**
**Kawasaki-shi Kanagawa-ken 210 (JP)**

(72) Inventor: **Ishida, Tsuyoshi c/o Patent Division**
**Tokyo Shibaura Denki K. K. 72, Horikawa-cho**
**Saiwai-ku Kawasaki-shi Kanagawa-ken (JP)**

(74) Representative: **Kirk, Geoffrey Thomas et al**
**BATCHELLOR, KIRK & EYLES 2 Pear Tree Court**
**Farringdon Road**
**London EC1R 0DS (GB)**

## Description

This invention relates to a device for detecting the presence of a metal strip embedded in a sheet of paper, particularly currency notes or cheques, in order to verify the authenticity of the currency note or cheque.

In recent years, the high quality of copying or printing machines has resulted in a serious counterfeiting problem. One of the countermeasures against counterfeiting which has been adopted in many countries is the presence of a metal strip embedded in paper currency notes or cheques. However, metal detectors for automatically discriminating between genuine and counterfeit currency notes and cheques by detecting the metal strip have not been put to extensive use because they have not been capable of accurate and reliable detection of the metal strip at high speed.

One known technique for detecting the metal strip embedded in paper money is disclosed in United Kingdom Patent Application No. 2017996. Figure 1(A) of the drawings of the present application illustrates the detecting system of this U.K. patent application. The detecting system includes a circuit formed by resistor R, self-induction coil L and adjustable variable capacitor C. A voltage $U_1$ having a frequency of 2MHz is applied to this circuit and an output voltage $U_2$ is measured at the terminals of capacitor C. The high frequency output voltage $U_2$ is modulated by movement of paper money P having a metal strip M in front of the coil L in the direction of the arrow. The metal strip M crosses the line of magnetic induction generated by coil L to modulate the output voltage $U_2$. However, a small variation in the space S between coil L and paper money P varies the number of lines of magnetic induction crossed by metal strip M and this causes a noticeable variation in output voltage $U_2$.

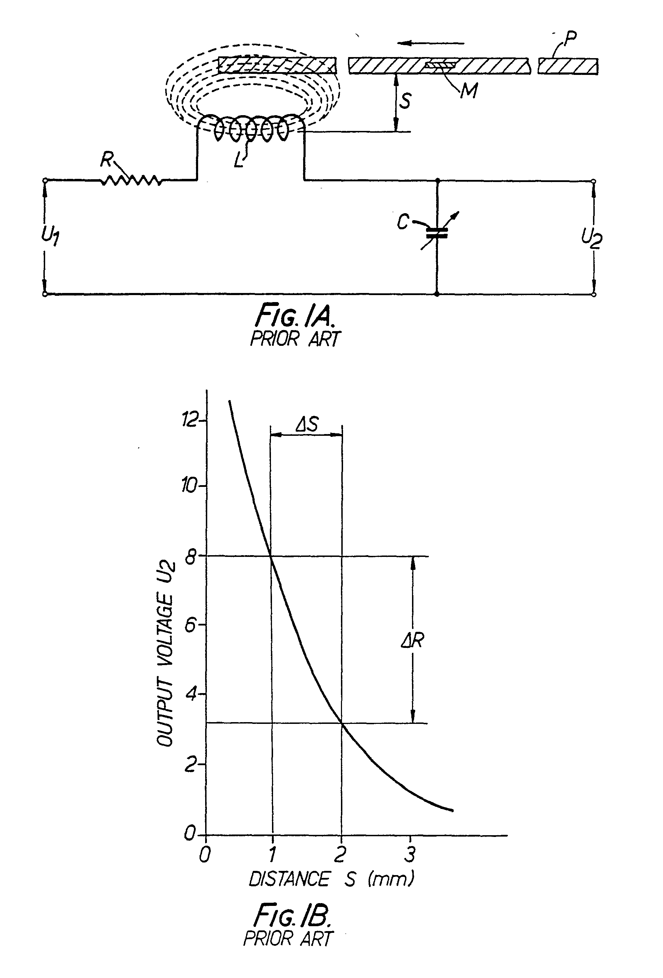

The graph of Figure 1(B) shows the variation of output voltage $U_2$ as a function of the variation in the space S between paper money P and coil L. As is apparent from this graph, the variation $\Delta R$ in output voltage $U_2$ is large compared to the space variation $\Delta S$ between paper money P and coil L. Since paper money P, such as a currency note, has to be transported at high speed relative to the coil, the space between the detecting coil and the currency note cannot be maintained constant. As a result, frequent detection errors occur in this prior art detecting system.

U.S—A—4 108 296 discloses an arrangement for checking characteristics of coins, in which the coin passes through a detection path located between two coils, one coil forming the primary winding of a transformer, the other one forming the secondary winding. The characteristics of the coins passing therethrough are checked by determining the influence of eddy-currents induced in the coin by the primary on the signal produced by the secondary.

In addition GB—A—595 764 discloses checking of the presence of metal strips in bank notes by passing said bank notes through a measuring head comprising an inductance coil whose voltage is influenced by the presence of a metal strip.

Again, however, neither of these prior art devices discloses a system capable of accurately detecting metal strips in banknotes because they are not capable of discriminating between correctly sized and positioned metal strips, and those which are (for example) of the wrong width or not oriented correctly.

The invention overcomes the prior art disadvantages mentioned above by providing a practical and effective device for detecting a metal strip in paper, particularly paper money.

According to the present invention there is provided a detecting device for detecting an oblong sheet of genuine paper money including an embedded metal strip extending across the sheet and having a predetermined width and a length substantially equal to the width of the sheet, and transporting means for rapidly transporting the sheet in the direction of its length along a transportation path; said detecting device comprising a detection circuit including coil means;

current supply means for supplying AC current to said detection circuit to generate a magnetic field; capacitive means connected in said detection circuit so as to form a resonant circuit; and detection means connected to said resonant circuit so as to detect variations in the resonance signal of said circuit caused by eddy current losses in said metal strip when said strip passes said detection circuit;

characterised in that said coil means comprises first coil means comprising a transmitter which is arranged on one side of said path and which is connected to said current supply means;

second coil means comprising a receiver which is arranged on the other side of said path and which is connected to said capacitive means and in that the plane of each said coil means extends parallel to the surface of the sheet (P) the coils being elongated in a direction perpendicular to the transportation direction (A), and the width of each coil, in the transportation direction, being somewhat greater than the width of said strip.

Other objects and features of the present invention will be apparent from the following description taken in connection with the accompanying drawings, in which:—

Figure 1(A) is a schematic view showing a prior art device for detecting the presence of a metal strip in paper money,

Figure 1(B) is a graph of the output voltage as a function of space variations of the device shown in Figure 1(A),

Figure 2(A) is a plan view of a bank note having a metal strip embedded therein,

Figure 2(B) is a sectional view on the line 2B—2B of Figure 2(A),

Figure 3(A) is a plan view of a device for detecting metal strip in paper according to the present invention,

Figure 3(B) is a side view of the device shown in Figure 3(A),

Figure 4 is a circuit diagram of the device shown in Figures 3(A) and 3(B),

Figures 5(a)—5(e) are signal waveform diagrams for the circuit diagram of Figure 4,

Figure 6 is an output graph of the device shown in Figure 4,

Figure 7(A) is a plan view of another embodiment of the device according to the present invention,

Figure 7(B) is an end view of the device shown in Figure 7(A),

Figure 7(C) is a side view of the device shown in Figure 7(A),

Figure 8 is a circuit diagram of the device shown in Figures 7(A), 7(B) and 7(C),

Figure 9 is a circuit diagram showing a modification of the circuit shown in Figure 8,

Figure 10(A) is a plan view of another embodiment of the device according to the present invention,

Figure 10(B) is an end view of the device shown in Figure 10(A),

Figure 10(C) is a side view of the detecting device shown in Figure 10(A),

Figure 11 is a circuit diagram of the detecting device shown in Figures 10(A), 10(B) and 10(C),

Figure 12 is a circuit diagram showing a modification of the electric circuit shown in Figure 10,

Figure 13(A) is a plan view of still another embodiment of the device according to the present invention,

Figure 13(B) is a side view of the device shown in Figure 13(A),

Figure 14 is a circuit diagram of the device shown in Figures 13(A) and 13(B),

Figures 15(a)—15(f) are signal waveform diagrams for the circuit diagram shown in Figure 14, and

Figures 16(a)—16(f) are signal waveform diagrams for the circuit diagram shown in Figure 14 in the event that the metal strip is cut or broken.

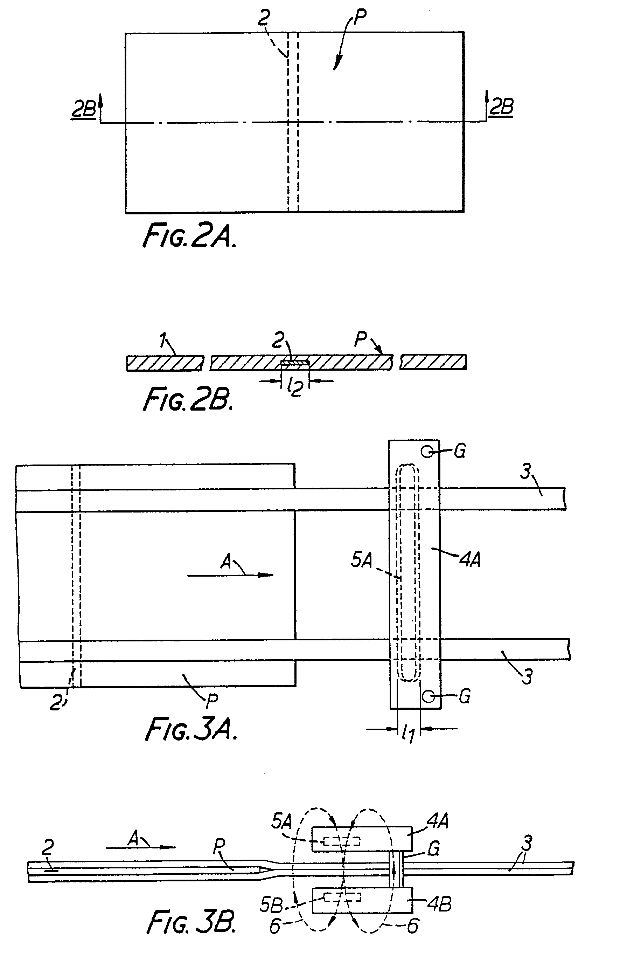

As shown in Figures 2(A) and 2(B), a paper bank note P has a metal strip 2 embedded in it. This metal strip 2 is made of material such as aluminium which is about 20 μm thick, has a width $1_2$ of about 0.5—1.0 mm and has a length which is the same as the width of the bank note. The metal strip 2 is embedded crosswise of the paper P, i.e. in a direction perpendicular to the lengthwise direction of the bank note.

As shown in Figures 3(A) and 3(B), the paper bank note P is transported in the direction of arrow A between a pair of spaced apart detecting heads 4A, 4B by transporting belts 3. Paper money P is transported clamped between the transporting belts 3 so that it moves in a direction parallel to its length. Detecting head 4A is the upper detecting head and detecting head 4B is the lower head. The detecting heads 4A and 4B are perpendicular to the transporting direction A and face each other at a spacing of about 5 mm provided by spacers G. The detecting heads 4A and 4B, which are made of epoxy resin carry elongate wound coils 5A and 5B, respectively. The lateral width $1_1$ of the coils is larger than width $1_2$ of metal strip 2 in paper money P so that it is possible to detect the metal strip 2 even when paper money P is off centre as it is transported past the coils. Each coil 5A, 5B is parallel to the surface of paper money P and perpendicular to the transportation direction A. Paper money P is transported between the detecting heads 4A and 4B without contacting them.

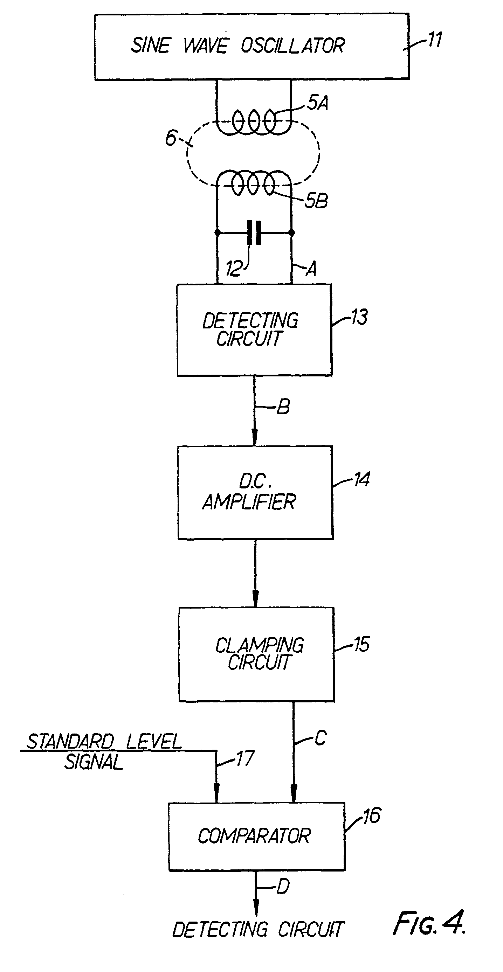

Figure 4 shows a circuit connected to the coils 5A and 5B of the detecting device. The electric circuit comprises the following parts: a sine wave oscillator 11 for supplying a 1MHz signal to transmitting coil 5A of detecting head 4A; a capacitor 12 for forming a parallel resonance circuit with receiving coil 5B; a detecting circuit 13 for converting the AC signal (resonance signal) across capacitor 12 into a DC signal by envelope detecting; a DC amplifier 14 for amplifying the output signal of detecting circuit 13; a clamp circuit 15 for clamping the output signal of DC amplifier 14; and a comparator 16 for comparing the output signal of clamp circuit 15 with a predetermined signal level 17 to generate a binary signal.

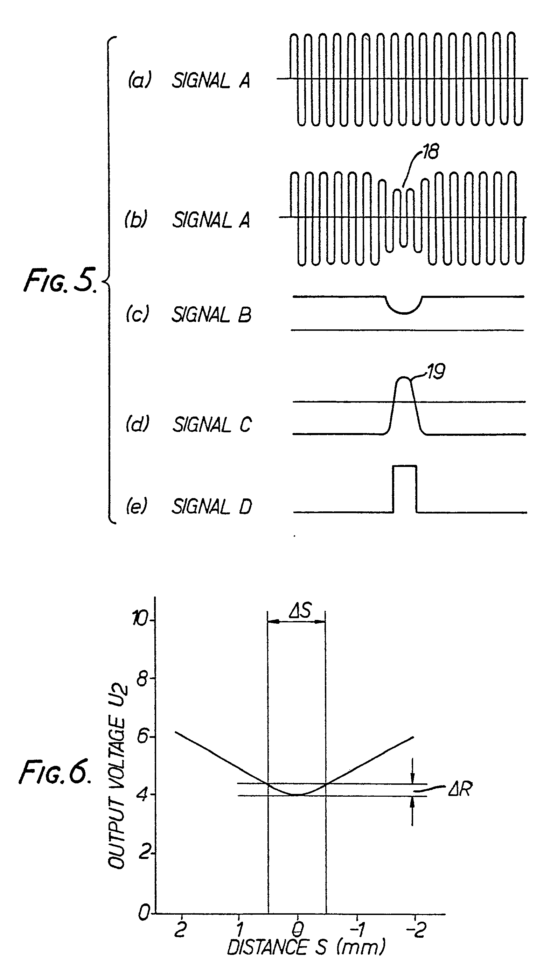

The detecting device operates as follows. When the 1MHz signal is supplied to transmitting coil 5A by oscillator 11, magnetic field 6 shown in Figure 3(B) is formed. The high frequency magnetic field 6 induces a voltage in receiving coil 5B. When paper money is not being transported, the resonance circuit formed by receiving coil 5B and capacitor 12 resonate in response to the high frequency signal in accordance with the equation $Q=\omega L/R$. The resonance signal A across the capacitor 12 is shown in Figure 5(a). In the event that paper money P with a metal strip 2 is transported through the space between detecting heads 4A and 4B, metal strip 2 passes through the magnetic field 6. The metal strip 2 produces an eddy-current loss in the magnetic field which increases the resistance R and decreases the Q factor. As the Q factor of the resonance circuit decreases, the amplitude of resonance signal A decreases. The decreased resonance signal A is detected by detecting circuit 13 which generates signal B shown in Figure 5(c) (the envelope of AC signal in Figure 5(b)). The output signal B of detecting circuit 13 is supplied to clamp circuit 15 after being amplified by amplifier 14. At clamp circuit 15, as shown by signal C in Figure 5(d), signal B is clamped at a constant electric potential, except signal part 19 corresponding to detection of metal strip P. Output signal C of clamp circuit 15 is supplied to comparator 16 and converted into the binary signal D shown in Figure 5(e) by comparison with a predetermined signal level 17. The binary signal D is transmitted to a discriminating device (not shown) for discriminating between genuine and counterfeit paper money P.

The output characteristics of the abovementioned embodiment are shown in Figure 6. The variation ΔR in the output signal is very small compared to the variation ΔS of the space between paper money P and detecting coil 5B. Since paper money P crosses the magnetic flux between the first and second coils 5A and 5B, the variation ΔS in the space between paper money P and the detecting coil 5B has little effect on the output signal of the device. Therefore, reliable detection of metal strip 2 in paper money P can be carried out at high speed in the detecting device of the present invention.

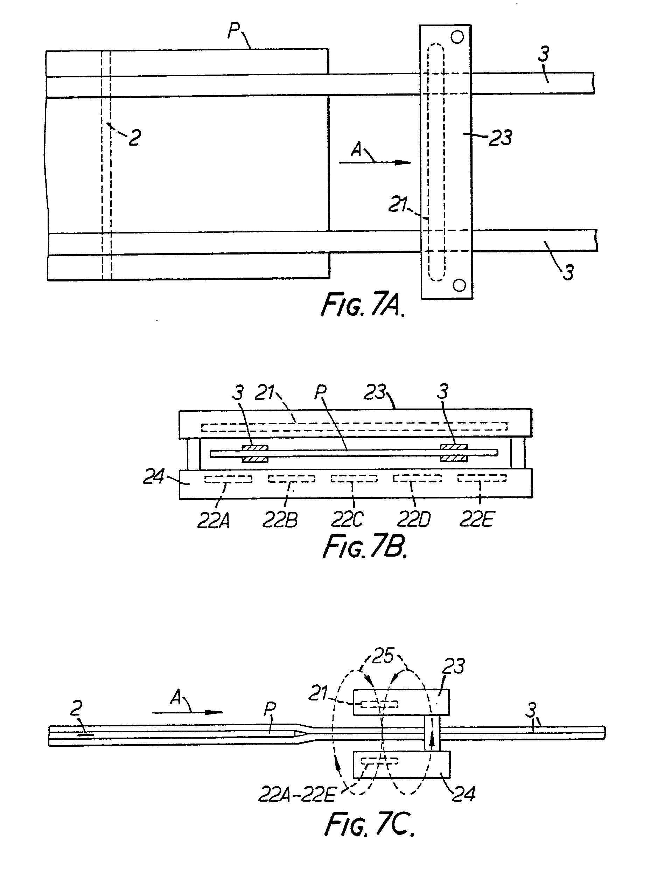

Another embodiment according to the present invention is shown in Figures 7(A), 7(B) and 7(C). A ring type transmitting coil 21 is embedded in the upper detecting head 23 and five ring type receiving coils 22A—22E are embedded in the lower detecting head 24. Each coil 22A—22E is aligned along a line normal to direction A. The widths of transmitting coil 21 and all receiving coils 22A—22E are greater (in the direction of travel A) than that of metal strip 2 in paper money P. High frequency magnetic field 25 induces a voltage in receiving coils 22A—22E.

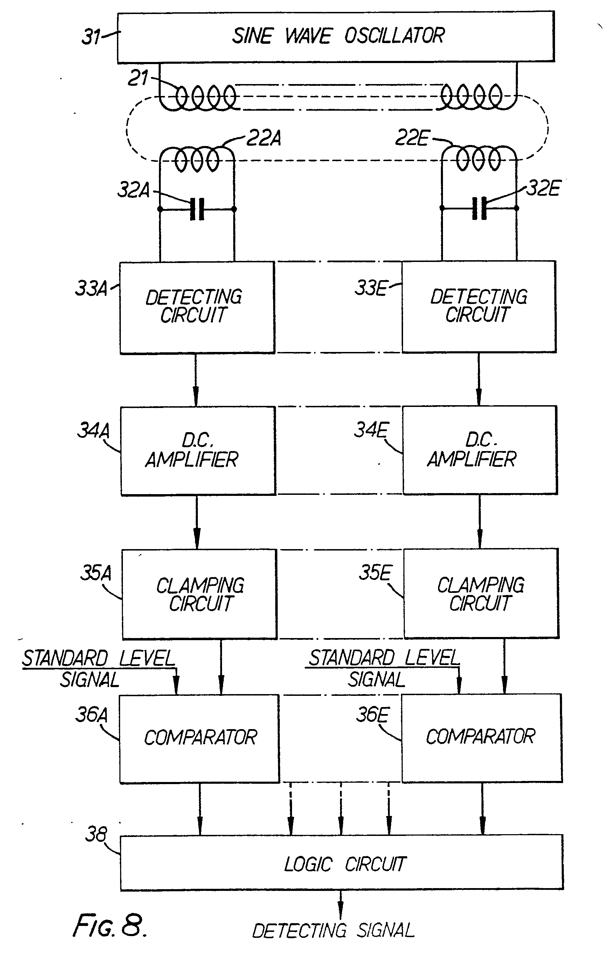

Figure 8 shows the electric circuit for the detector shown in Figure 7. In this circuit, each receiving coil 22A—22E is connected, as in the aforementioned embodiment shown in Figure 4, to one of the capacitors 32A—32E, one of the detecting circuits 33A—33E, one of the DC amplifiers 34A—34E, one of the clamp circuits 35A—35E and one of the comparators 36A—36E, respectively. Output signals of comparators 35A—35E are supplied to a logic circuit 38 for generating the final output detecting signal. The logic circuit 38 is a standard logic circuit which is designed to output the final output detecting signal when a predetermined number of comparators 36A—36E generate metal detecting signals simultaneously. Metal strip 2 normally is a continuous metal strip embedded in paper P, but this strip 2 can be partially cut or broken when paper P is bent or folded. If the metal strip 2 is broken, the output of the receiving coil corresponding to the broken portion is very small. But, in this embodiment, since the final output detecting signal from logic circuit 38 is only generatd when, say, at least three or four of the comparators 36A—36E detect metal strip 2 simultaneously, a broken portion in the metal strip does not prevent a determination that the metal strip is present. The final output detecting signal is sent to a note evaluating device (not shown) to determine whether paper P, such as a currency note, is genuine or counterfeit.

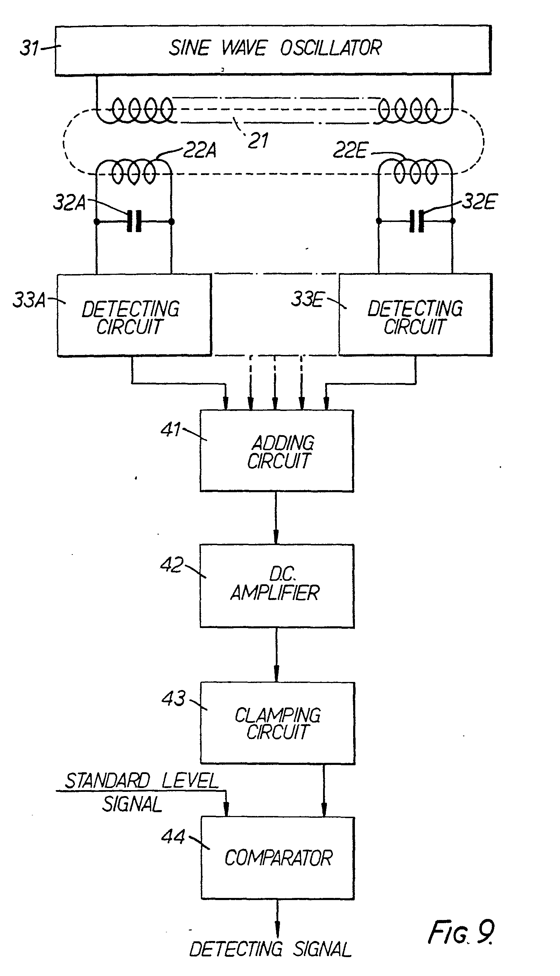

Figure 9 shows a modification of the circuit of the embodiment shown in Figure 8. In the modification, the outputs of detecting circuits 33A—33E are combined in an adding circuit 41, amplified by a DC amplifier 42 and is clamped by a clamping circuit 43. The clamping output is converted to a binary signal by a comparator 44. Thus, the same object can be achieved as in the embodiment shown in Figure 8. According to this modification, only one DC amplifier 42, one clamping circuit 43 and one comparator 44 are necessary, and no logic circuit 38 is needed.

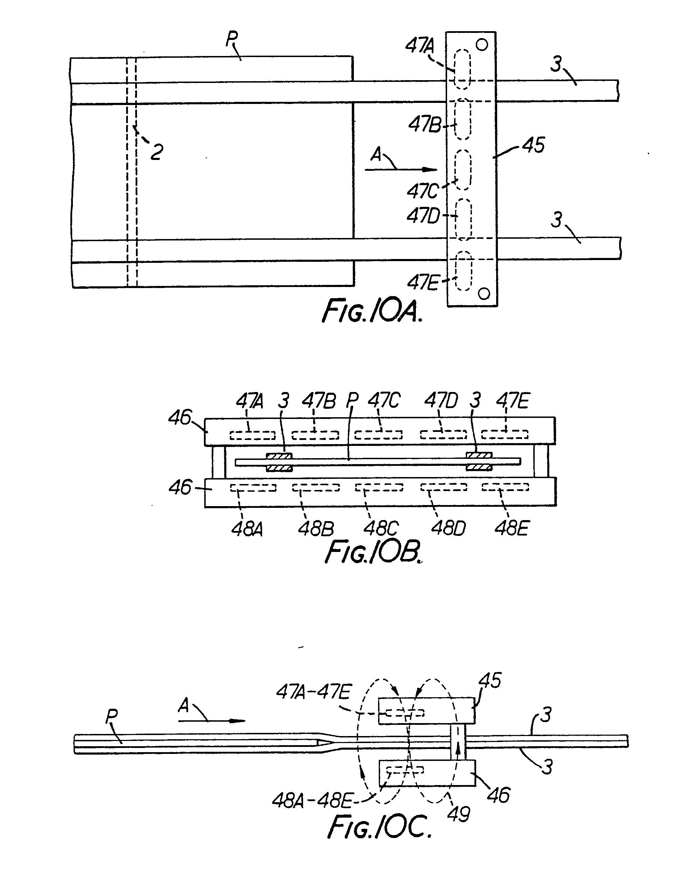

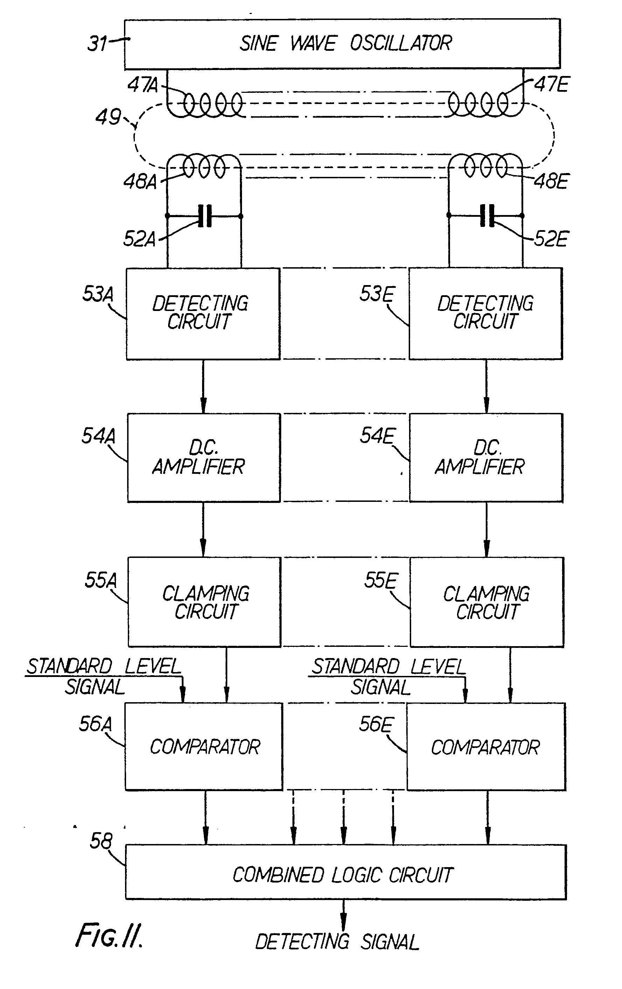

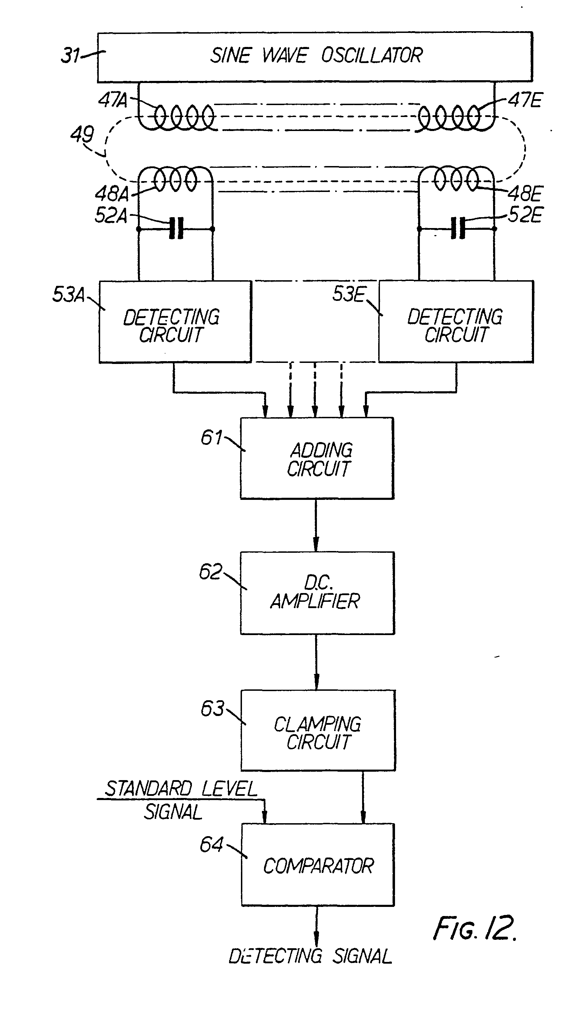

Figures 10(A), 10(B) and 10(C) show another embodiment of the detecting device of the present invention. In this embodiment, transmitting coil 5 is divided into five coils 47A—47E which face receiving coils 48A—48E, respectively. High frequency magnetic field 49 induces a voltage in receiving coils 48A—48E. The electric circuits for these embodiments are shown in Figure 11 and Figure 12. The circuit in Figure 11 corresponds to that in Figure 8 and the circuit in Figure 12 corresponds to that in Figure 9. The same object can be achieved as in the aforementioned embodiments.

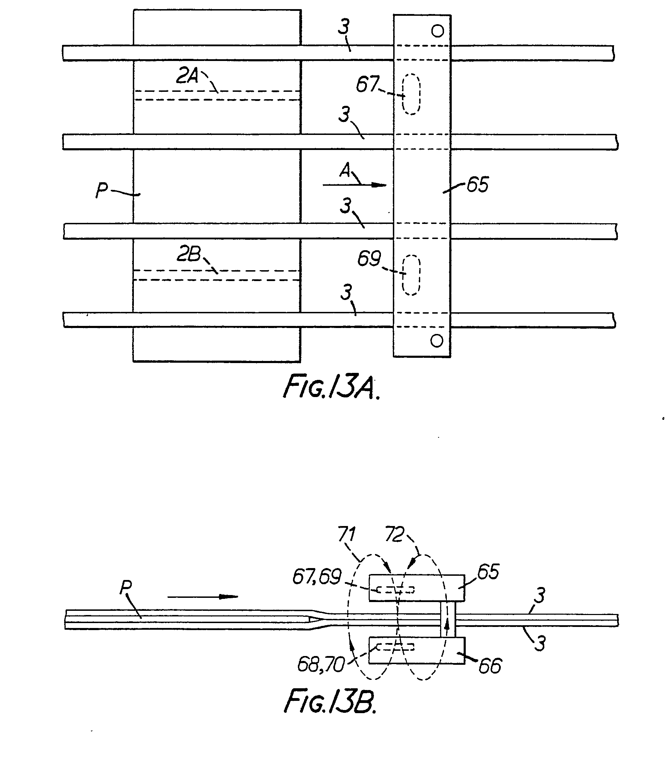

In still another embodiment of the invention shown in Figures 13(A), 13(B) and 13(C), paper money P is transported in the crosswise or lateral direction. Metal strip 2A in paper money P is parallel to the direction of transportation A. In the event that the paper money P is transported up side down, the metal strip would be in the position shown by 2B in Figure 13(A). Two transmitting coils 67 and 69 are formed in detecting head 65 and two receiving coils 68 and 70 are formed in corresponding detecting head 66. Transmitting coil 67 and receiving coil 68, as well as transmitting coil 69 and receiving coil 70, are arranged to face each other between transporting belts 3 approximately at positions corresponding to metal strip 2A, 2B. The length of each coil 67—70 is greater than the width of metal strip 2A or 2B to compensate for the possible misalignment of paper money P on the transporting belts 3. Each transmitting coil 67 and 69 generates magnetic flux 71, 72 for engaging receiving coils 68 and 70.

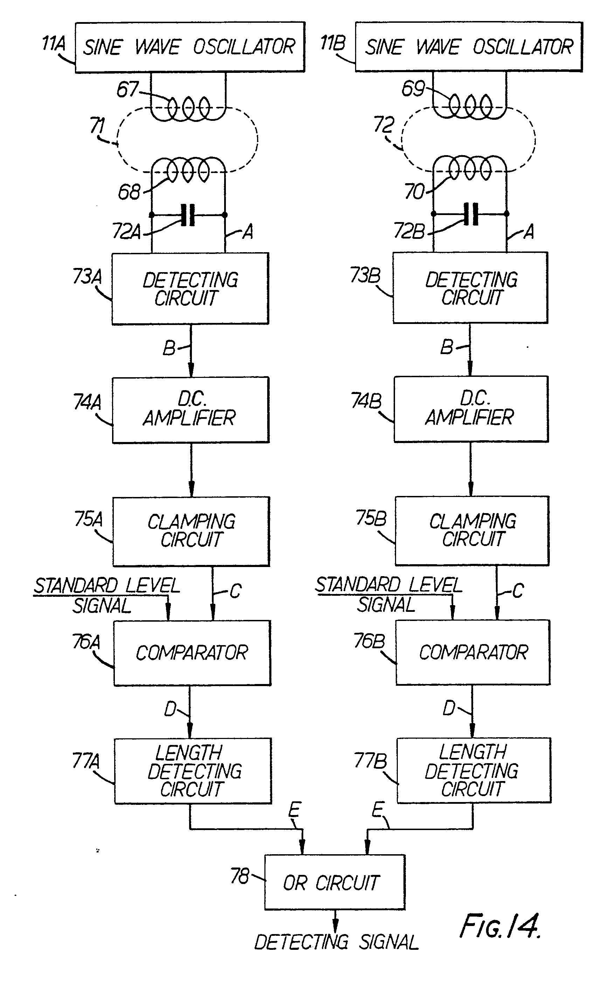

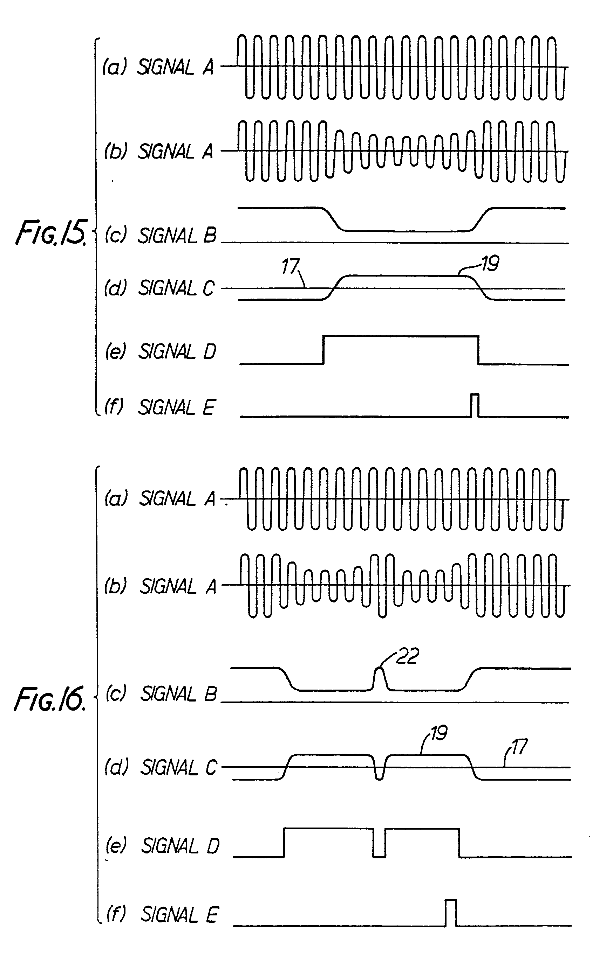

Figure 14 shows the electric circuit for the detector shown in Figure 13. Sine wave oscillators 11A and 11B supply high frequency signals to transmitting coils 67 and 69, respectively. Each receiving coil 68, 70 is connected, as in the embodiment shown in Figure 4, to capacitor 72A, 72B, detecting circuit 73A, 73B, DC amplifier 74A, 74B, clamp circuit 75A, 75B and comparator 76A, 76B, respectively. Output signals of comparators 76A and 76B are separately supplied to length detecting circuits 77A or 77B for measuring the time period of the binary signals of each comparator 76A and 76B. The output signals of length detecting circuits 77A or 77B detects a metal strip, a signal is generated by the OR circuit 78 indicating the existence of the metal strip. When the metal strip in paper money P is positioned in location 2A, the output of detecting circuit 73A is shown by signal B in Figures 15(c) or 16(c). Figure 16 shows the waveforms for the circuit of Figure 14 in the event the metal strip is cut or broken. The pulse 22 in Figure 16(c) illustrates the response of the circuit to the broken part of the strip. The signal B is clamped in clamp circuit 75A, which generates signal C shown in Figure 15(d) or Figure 16(d). The clamp circuit 75A clamps signal B at a fixed potential, except for the detecting signal part 19 corresponding to metal strip 2. The output signal C of clamp circuit 75A is supplied to comparator 76A for comparison with the reference level signal 17, which results in a binary signal D as shown in Figures 15(e) or 16(e). The signal D is supplied to length detecting circuit 77A which is formed by conventional counters, and the time period is checked to determine if it is of sufficient length. When the time period is greater than a specified amount, the output signal E of Figure 15(e) or 16(e) is generated. The output signal E is the output detecting signal of metal strip 2A. This signal is sent to a discriminating device (not shown) through OR circuit 78 and is used to determine whether paper money P is genuine or counterfeit.

Although illustrative embodiments of the invention have been described in detail with reference to the accompanying drawings, it is to be understood that the invention is not limited to those precise embodiments and that various changes and modifications may be effected therein by one skilled in the art without departing from the scope of the invention.

## Claims

1. A detecting device for detecting an oblong sheet of genuine paper money including an embedded metal strip extending across the sheet and having a predetermined width and a length substantially equal to the width of the sheet, and transporting means for rapidly transporting the sheet in the direction of its length along a tansportation path; said detecting device comprising a detection circuit including coil means;

current supply means for supplying AC current to said detection circuit to generate a magnetic field; capacitive means connected in said detection circuit so as to form a resonant circuit; and detection means connected to said resonant circuit so as to detect variations in the resonance signal of said circuit caused by eddy current losses in said metal strip when said strip passes said detection circuit;

characterised in that said coil means comprises first coil means (5a) comprising a transmitter which is arranged on one side of said path and which is connected to said current supply means; and

second coil means 5(b) comprising a receiver which is arranged on the other side of said path and which is connected to said capacitive means (12) and in that the plane of each said coil means extends parallel to the surface of the sheet (P), the coils being elongated in a direction perpendicular to the transportation direction (A), the width $(1_1)$ of each coil, in the transportation direction, being somewhat greater than the width of said strip $(1_2)$.

2. A device as claimed in claim 1, characterised in that the length of each of the first and second coils is greater than the width of the paper transportable along said path.

3. A device as claimed in claim 1, characterised in that the second coil means comprises a plurality of individual coils arranged in line at right angles to the direction of transportation, each individual coil being linked with the magnetic field generated by the first coil and each individual coil having a capacitor connected in circuit therewith and detecting means connected to each circuit to detect variations in the circuit caused by eddy-current losses in the metal strip in paper transported between the coils.

4. A device as claimed in claim 3, characterised in that the first coil means comprises a plurality of individual coils, equal in number to the individual coils of the first coil and arranged in line at right angles to the direction of transportation.

5. A device as claimed in claim 1, in which the transporting means is adapted to transport currency notes with the metal strip in each note parallel to the direction of transportation, characterised in that each of the first and second coils comprises two separate parts positioned in line at right angles to the direction of transportation, with one part of each coil in the vicinity of the metal strip in a currency note transported along the path and the other part of each coil in the vicinity of the metal strip in an inverted currency note transported along said path.

6. A device as claimed in claim 1 or 2, characterised in that said detecting means comprises a detector for detecting the signal in said circuit, a clamp circuit for clamping the output of said detecting circuit and a comparator for comparing the output of said clamp circuit and producing a binary signal.

7. A device as claimed in claim 1, 2, or 6, characterised in that said capacitor is connected in parallel with the second coil.

8. A device as claimed in claims 1, 2, 6 or 7, characterised in that the AC energy is supplied by a high frequency oscillator connected to the first coil.

9. A device as claimed in claim 5, characterised in that each part of the second coil has a capacitor connected in circuit therewith, detecting means are connected to each of said circuits to detect variations in the circuits caused by eddy current loss in the metal strip in paper transported between the coils and each part of the first coil has a separate AC energy source connected thereto.

10. A device as claimed in claim 3, characterised in that said detecting means comprises a detector for each circuit, a clamping circuit connected to each of said detecting circuits for clamping the output of each detecting circuit, a comparator connected to each of said clamping circuits for comparing the output of each clamping circuit and producing a binary signal and a logic circuit for generating an output detecting signal by combination of a predetermined number of the outputs of each of said comparators.

11. A device as claimed in claim 3, characterised in that said detecting means comprises a detector connected to each of said circuits and an adding circuit connected to said detecting circuits for adding the outputs of said detecting circuits, a clamping circuit connected to said adding circuit for clamping the output of said adding circuit and a comparator connected to said clamping circuit for comparing the output of said clamping circuit and producing a binary signal.

**Patentansprüche**

1. Vorrichtung zur Feststellung eines in einem länglichen, echten Blatt Papiergeld eingebetteten Metallstreifens, der quer über das Blatt verläuft und eine vorbestimmte Breite aufweist und eine Länge, die im wesentlichen gleich ist der Breite des Blattes, mit einer Transportvorrichtung zum schnellen Transport des Blattes in der Richtung seiner Länge entlang eines Transportsweges, wobei die Feststellvorrichtung einen Prüfschaltkreis mit einer Spulenanordnung aufweist, eine Stromversorgungseinrichtung zum Zuführen eines Wechselstromes zum Prüfschaltkreis, um ein Magnetfeld zu erzeugen, eine im Prüfschaltkreis ausgebildete Kondensatoranordnung zur Bildung eines Resonanzschaltkreises und Prüfmittel, die mit dem Resonanzschaltkreis verbunden sind, um Änderungen im Resonanzsignal des Schaltkreises zu erfassen, die verursacht sind durch Wirbelstromverluste im Metallstreifen, wenn dieser Streifen den Prüfschaltkreis passiert, dadurch gekennzeichnet, daß die Spulenanordnung eine erste Spulenanordnung (5a) mit einem Übertrager aufweist, der an einer Seite des Weges angeordnet ist und mit der Stromversorgungseinrichtung verbunden ist, und eine zweite Spulenanordnung (5b), die einen Empfänger aufweist, der an der anderen Seite des Weges angeordnet ist und mit der Kondenatoranordnung (12) verbunden ist, und daß die Ebene jeder Spulenanordnung parallel zur Oberfläche des Blattes (P) verläuft, wobei die Spulen in einer senkrecht zur Transportrichtung (A) verlaufenden Richtung gestreckt sind und die Breite $(1_1)$ jeder Spule in der Transportrichtung etwas größer ist als die Breite des Streifens $(1_2)$.

2. Vorrichtung nach Anspruch 1, dadurch gekennzeichnet, daß die Länge jeder der ersten und zweiten Spulen größer ist als die Breite des entlang des Weges transportierbaren Papiers.

3. Vorrichtung nach Anspruch 1, dadurch gekennzeichnet, daß die zweite Spulenanordnung mehrere einzelne Spulen aufweist, die in einer Reihe rechtwinklig zur Transportrichtung angeordnet sind, wobei jede einzelne Spule mit dem durch die erste Spule erzeugten Magnetfeld in Wirkverbindung steht, und wobei jede einzelne Spule mit einem Kondensator verschaltet ist, sowie Prüfmittel, die mit jedem Schaltkreise verbunden sind, um Änderungen im Schaltkreis zu erfassen, die durch Wirbelstromverluste in dem zwischen den Spulen transportierten im Papier befindlichen Metallstreifen verursacht sind.

4. Vorrichtung nach Anspruch 3, dadurch gekennzeichnet, daß die erste Spulenanordnung mehrere einzelne Spulen aufweist, die zahlenmäßig den einzelnen Spulen der ersten Spulenanordnung gleich sind und in Reihe rechtwinklig zur Transportrichtung angeordnet sind.

5. Vorrichtung nach Anspruch 1, bei der Transportmittel zum Transport von Banknoten, die jeweils mit dem Metallstreifen versehen sind, parallel zur Transportrichtung ausgebildet sind, dadurch gekennzeichnet, daß jede der ersten und zweiten Spulen zwei in Reihe unter rechten Winkeln zur Transportrichtung positionierte getrennte Teile aufweist, wobei ein Teil jeder Spule in der Nähe des Metallstreifens einer entlang des Weges transportierten Banknote und der andere Teil jeder Spule in der Nähe des Metallstreifens einer entlang des Weges transportierten umgekehrten Banknote angeordnet ist.

6. Vorrichtung nach Anspruch 1 oder 2, dadurch gekennzeichnet, daß die Prüfmittel einen Detektor zum Abtasten des Signales in dem Schaltkreis aufweisen, einen Blockierschaltkreis zum Blockieren des Ausgangssignales des Prüfschaltkreises sowie einen Vergleicher zum Vergleich des Ausgangssignales des Blockierschaltkreises mit einem vorbestimmten Signalpegel und zum Erzeugen eines Binärsignales.

7. Vorrichtung nach Anspruch 1, 2 oder 6, dadurch gekennzeichnet, daß der Kondensator parallel zur zweiten Spule geschaltet ist.

8. Vorrichtung nach Anspruch 1, 2, 6 oder 7, dadurch gekennzeichnet, daß die Wechselspannung durch einen Hochfrequenzoszillator erzeugt wird, der mit der ersten Spule verbunden ist.

9. Vorrichtung nach Anspruch 5, dadurch gekennzeichnet, daß jeder Teil der zweiten Spule mit einem Kondensator verschaltet ist, Prüfmittel mit jedem der Schaltkreise verbunden sind, um Änderungen im Schaltkreis zu erfassen, die durch einen Wirbelstromverlust in zwischen den Spulen transportierten im Papier befindlichen Metallstreifen erzeugt werden, und daß jedes Teil der ersten Spule an eine getrennte Wechselspannungsquelle angeschlossen ist.

10. Vorrichtung nach Anspruch 3, dadurch gekennzeichnet, daß die Prüfmittel einen Detektor für jeden Schaltkreis umfassen, einen Blockierschaltkreis, der mit jedem der Prüfschaltkreise verbunden ist, zum Blockieren des Ausgangssignales jedes Prüfschaltkreises, einen Vergleicher, der mit jedem der Blockierschaltkreise verbunden ist, zum Vergleichen des Ausgangssignales jedes Blockierschaltkreises und zum Erzeugen eines Binärsignales, und einen logischen Schaltkreis zur Erzeugung eines Ausgangsprüfsignales durch Kombination einer vorbestimmten Zahl von Ausgangssignalen jedes der Vergleicher.

11. Vorrichtung nach Anspruch 3, dadurch gekennzeichnet, daß die Prüfmittel einen Detektor aufweisen, der mit jedem der Schaltkreise verbunden ist, und einen Addierkreis, der mit den Prüfschaltkreisen verbunden ist, zum Addieren der Ausgangssignale der Prüfschaltkreise, einen Blockierschaltkreis, der mit Addierkreisen verbunden ist, zum Blockieren des Ausgangssignales des Addierschaltkreises, und einen Vergleicher, der mit dem Blockierschaltkreis verbunden ist zum Vergleich des Ausgangssignales des Blockierschaltkreises und zum Erzeugen eines Binärsignales.

**Revendications**

1. Dispositif pour détecter la présence d'une feuille allongée de papier-monnaie authentique dans laquelle est encastrée une bande de métal s'étendant transversalement et ayant une largeur prédéterminée et une longueur sensiblement égale à largeur de ladite feuille, et incluant des moyens pour transporter rapidement ladite feuille dans la direction de son axe longitudinal le long d'un certain trajet; lesdits moyens de détection comprenant un circuit de détection incluant des bobines; des moyens pour alimenter en courant alternatif ledit circuit de détection afin d'engendrer un champ magnétique; des éléments capacitifs connectés audit circuit de détection de manière à former un circuit résonnant; et des moyens connectés audit circuit résonnant de manière à détecter les variations du signal de résonance dudit circuit dues aux pertes par courants tourbillonnaires ou de Foucault dans ladite bande de métal quand celle-ci passe devant ledit circuit de détection; caractérisé en ce que lesdites bobines comprennent une première bobine (5a) constituant un émetteur qui est disposé d'un côté dudit trajet et qui est connecté à ladite alimentation électrique; et une seconde bobine (5b) constituant un récepteur qui est disposé de l'autre côté dudit trajet et est connecté auxdits éléments capacitifs (12); et en ce que le plan de chacune desdites bobines s'étend parallèlement à la surface de la feuille (P), ces bobines s'étendant dans une direction perpendiculaire à la direction de transport (A), la largeur de chaque bobine $(1_1)$, dans la direction de transport, étant légèrement supérieure à la largeur de ladite bande $(1_2)$.

2. Dispositif selon la revendication 1, caractérisé en ce que la longueur de la première et de la seconde bobines est supérieure à la largeur de la feuille de papier transportable le long dudit trajet.

3. Dispositif selon la revendication 1, caractérisé en ce que la seconde bobine se compose d'un certain nombre de bobines individuelles alignees perpendiculairement à la direction de transport, chacune de ces bobines individuelles étant exposée au champ magnétique généré par la première bobine, et en ce que, à chaque bobine individuelle est connecté un condensateur, cependant que des moyens de détection sont connectés à chaque circuit afin de détecter les variations que provoquent dans le circuit les pertes par les courants tourbillonnaires ou de Foucault crées dans la bande de métal de la feuille de papier transportée entre les bobines.

4. Dispositif selon la revendication 3, caractérisé en ce que la première bobine comprend plusieurs bobines individuelles, dont le nombre est égal à celui des bobines individuelles de la première bobine et qui sont alignées perpendiculairement à la direction de transport.

5. Dispositif selon la revendication 1, dans lequel les moyens de transport sont adaptés à transporter des billets de banque dont chacun renferme une bande de métal s'étendant parallèlement à la direction de transport, caractérisé en ce que la première et la seconde bobines comprennent, chacune, deux parties séparées, alignées perpendiculairement á la direction de transport, une partie de chaque bobine étant placée à proximité de la bande de métal présente dans le billet de banque transporté le long dudit trajet, tandis que la seconde partie de chaque bobine est placée à proximité de la bande de métal d'un billet de banque inversé transporté le long dudit trajet.

6. Dispositif selon la revendication 1 ou 2, caractérisé en ce que lesdits moyens de détection comprennent un détecteur pour détecteur les signaux dans ledit circuit, un circuit de fixation ou circuit "clamp" pour fixer le niveau de sortie dudit circuit de détection, et un comparateur pour comparer les signaux de sortie dudit circuit clamp et pour produire un signal binaire.

7. Dispositif selon l'une quelconque des revendications 1, 2 ou 6, caractérisé en ce que ledit condensateur est branché en parallèle sur la seconde bobine.

8. Dispositif selon l'une quelconque des revendications 1, 2, 6 ou 7, caractérisé en ce que l'énergie alternative est fournie par un oscillateur de haute fréquence connecté à la première bobine.

9. Dispositif selon la revendication 5, caractérisé en ce que, à chaque partie de la seconde bobine est connecté un condensateur, des moyens de détection étant connectés à chacun desdits circuits afin de détecter les variations causées par les pertes par les courants de Foucault crées dans la bande de métal de la feuille de papier transportée entre les bobines, une source d'énergie électrique alternative séparée étant connectée à chaque partie de la première bobine.

10. Dispositif selon la revendication 3, caractérisé en ce que lesdits moyens de détection comprennent un détecteur pour chaque circuit, un circuit de fixation ou "clamp" connecté à chacun desdits circuits de détection afin de fixer le niveau de sortie de chacun des circuits de détection, un comparateur connecté à chacun desdits circuits clamp ou de fixation afin de comparer les signaux de sortie de chaque circuit de fixation et pour produire un signal binaire, et un circuit logique pour engendrer un signal de détection de sortie en combinant un nombre prédéterminé de signaux de sortie de chacun desdits comparateurs.

11. Dispositifs selon la revendication 3, caractérisé en ce que lesdits moyens de détection comprennent un détecteur connecté à chacun desdits circuits et un circuit d'addition connecté auxdits circuits de détection afin d'additionner les signaux de sortie de ces derniers, un circuit de fixation connecté audit circuit d'addition afin de fixer le niveau des signaux de sortie de ce dernier, et un comparateur connecté audit circuit de fixation afin de comparer les signaux de sortie de ce dernier et pour produire un signal binaire.

FIG. 1A.
PRIOR ART

FIG. 1B.
PRIOR ART

FIG.2A.

FIG.2B.

FIG.3A.

FIG.3B.

SINE WAVE OSCILLATOR — 11

5A

6

5B

12   A

DETECTING CIRCUIT — 13

B

D.C. AMPLIFIER — 14

CLAMPING CIRCUIT — 15

STANDARD LEVEL SIGNAL — 17   C

COMPARATOR — 16

D

DETECTING CIRCUIT   *FIG.4.*

FIG. 5.

(a) SIGNAL A

(b) SIGNAL A

18

(c) SIGNAL B

(d) SIGNAL C

19

(e) SIGNAL D

FIG. 6.

$\Delta S$

$\Delta R$

OUTPUT VOLTAGE U2

DISTANCE S (mm)

FIG. 7A.

FIG. 7B.

FIG. 7C.

0 057 972

Fig. 8.

DETECTING SIGNAL

6

0 057 972

FIG. 9.

7

FIG.IOA.

FIG.IOB.

FIG.IOC.

Fig. II.

DETECTING SIGNAL

Fig. 12.

FIG.13A.

FIG.13B.

Fig.14.

FIG.15.

(a) SIGNAL A

(b) SIGNAL A

(c) SIGNAL B

(d) SIGNAL C

(e) SIGNAL D

(f) SIGNAL E

FIG.16.

(a) SIGNAL A

(b) SIGNAL A

(c) SIGNAL B

(d) SIGNAL C

(e) SIGNAL D

(f) SIGNAL E